Europäisches Patentamt

(19) European Patent Office

Office européen des brevets

(11) Numéro de publication: **0 052 061 B1**

(12) **FASCICULE DE BREVET EUROPÉEN**

(45) Date de publication du fascicule du brevet:
04.09.85

(51) Int. Cl.⁴: **H 05 K 1/02, B 32 B 15/14**

(21) Numéro de dépôt: 81420165.3

(22) Date de dépôt: 03.11.81

(54) Procédé de préparation de substrats métallisés pour circuits imprimés.

(30) Priorité: 05.11.80 FR 8023943

(43) Date de publication de la demande:
19.05.82 Bulletin 82/20

(45) Mention de la délivrance du brevet:
04.09.85 Bulletin 85/36

(84) Etats contractants désignés:
AT BE CH DE FR GB IT LI LU NL SE

(56) Documents cités:
DE - A - 2 714 755
DE - A - 2 814 633
FR - A - 2 240 814
FR - A - 2 422 696

(73) Titulaire: RHONE-POULENC SPECIALITES CHIMIQUES,
"Les Miroirs" 18, Avenue d'Alsace, F-92400 Courbevoie
(FR)

(72) Inventeur: Cassat, Robert, Chemin de Crapon,
F-69360-Ternay (FR)
Inventeur: Vignando, Bruno, 52, rue Tramassac,
F-69005 Lyon (FR)

(74) Mandataire: Varnière-Grange, Monique et al,
RHONE-POULENC RECHERCHES Service Brevets
Chimie et Polymères Centre de Recherches de
Saint-Fons 85, avenue des Frères Perret B.P. 62,
F-69192 St-Fons Cédex (FR)

## Description

La présente invention se rapporte à un procédé de fabrication de substrats faits en une matière polymérique renforcée et revêtue de métal, destinés à la réalisation de circuits imprimés. Ces substrats métallisés sont désignés, dans la terminologie anglo-saxonne, par l'appellation «metalclad».

Pareils substrats sont bien connus de l'homme de l'art (cf. brevet américain No. 4 110 147). Ils comprennent généralement un matériau support isolant électriquement sur la face ou les deux faces duquel adhère une feuille métallique conductrice. Cette feuille métallique peut être notamment une feuille de cuivre, d'aluminium, de nickel, ou d'acier inoxydable ayant une épaisseur comprise entre 10 et 100 microns selon le type de circuit imprimé que l'on désire obtenir.

Les substrats métallisés dont on parle peuvent être rigides, semi-rigides ou flexibles selon la composition du matériau support isolant. Par substrat semi-rigide, on désigne un matériau pouvant supporter une déformation élastique par incurvation jusqu'à un rayon de courbure très faible.

Dans le cas des substrats métallisés rigides ou semi-rigides qui sont plus particulièrement visés par la présente invention, le matériau support isolant est constitué habituellement par l'empilement d'un certain nombre de préimprégnés qui résultent chacun de l'association, connue en soi, d'une charge de renforcement à structure allongée avec une matière polymérique. Avec une charge de renforcement courante telle que par exemple un tissu de verre de 200 g/m², on fait appel en moyenne à environ 12 préimprégnés. Les préimprégnés courants sont composés de papiers de cellulose, de tissus de coton ou de tissus de verre imprégnés à l'aide de polymères synthétiques. Les résines phénol-formol, polyester et surtout polyépoxy sont les produits les plus souvent employés. La charge de renforcement, papier ou tissu de verre, est en général imprégnée à l'aide d'une solution de polymère dans un solvant adéquat, ce qui permet une bonne pénétration du liant polymérique entre les fibres de la charge. La structure imprégnée passe ensuite dans un four porté à une température permettant l'évaporation du solvant.

La fabrication des substrats métallisés consiste à interposer entre les plateaux d'une presse l'empilement des préimprégnés recouvert d'une feuille métallique sur l'une ou sur ses deux faces suivant que l'on désire obtenir un substrat mono- ou bimétallisé. On presse ensuite à une température permettant l'association des différents constituants. Dans certains cas, les feuilles métalliques demandent l'intervention d'un moyen de collage pour adhérer de manière permanente sur les préimprégnés.

La demande DE-A-2 814 633 enseigne que l'on peut préparer un matériau de base constitué d'un compound calandré contenant une faible proportion de liant et de feuilles de surface contenant un excès de résine qui fluera pour permettre l'accrochage des différentes couches.

Etant donné que les substrats métallisés pour circuits imprimés sont de plus en plus demandés, il est souhaitable d'accroître les rendements de fabrication en réduisant le nombre des éléments, en particulier le nombre de préimprégnés, entrant dans leur constitution. Cette simplification au niveau de la fabrication doit être faite bien entendu sans entraîner une baisse des propriétés mécaniques et électriques à chaud.

Un autre but que vise la présente invention est de fournir des substrats métallisés dont la fabrication ne doit pas donner lieu à une pollution de l'environnement. Comme on l'a indiqué ci-avant, la préparation du matériau support isolant fait intervenir généralement un processus d'imprégnation d'une série de structures de renforcement à l'aide d'une solution de polymère dans un solvant adéquat. Afin d'obtenir un préimprégné utilisable pour la suite des opérations, on doit éliminer le solvant par séchage. Cette élimination du solvant, en dépit de toutes les précautions prises pour le récupérer, est souvent une cause de pollution. On ajoutera comme autres inconvénients liés à l'emploi de solvant, d'une part son prix d'achat, et d'autre part l'importante quantité d'énergie requise pour le séchage. La réduction du nombre des préimprégnés, dont on a parlé ci-avant pour simplifier la fabrication des substrats métallisés, apparait donc encore comme une manière de résoudre ce problème de pollution. La présente invention vise d'ailleurs à résoudre complètement ce problème en proposant d'écarter la voie collodion pour la préparation des préimprégnés restants.

Un autre but encore de la présente invention est de fournir des substrats métallisés pour circuits imprimés qui peuvent facilement être percés par un simple poinçonnement et dont la composition interne permet d'obtenir, en appliquant cette technique de perçage simplifiée, des trous à paroi nette pour le passage des jonctions électriques entre les deux faces.

D'autres buts et avantages de la présente invention apparaitront au cours de la description qui va suivre.

Il a maintenant été trouvé que l'on pouvait arriver à tout ou partie de ces buts grâce à un nouveau procédé de fabrication de substrats métallisés.

Ce procédé est caractérisé en ce qu'il consiste à empiler successivement:

(i) — une feuille métallique conductrice électriquement,

(ii) — un premier préimprégné constitué par un tissu ou un non-tissé de fibres de verre, d'amiante ou de fibres synthétiques thermostables imprégné au moyen d'un prépolymère thermodurcissable sous forme non réticulée,

(iii) — un feutre ou un compound constitué par une matière cellulosique ou des paillettes de mica et un prépolymère thermodurcissable sous forme non réticulée,

(IVi) — un second préimprégné tel que défini sous (ii),

(Vi) — éventuellement une seconde feuille métallique identique à (i), puis à presser l'empilement à une température permettant l'assemblage et la réticulation des différents éléments.

Par l'expression matière cellulosique, on entend le papier sous forme de pâte, de bande, les tissus, les tricots ou les couches de fibres formés de cellulose naturelle ou de cellulose modifiée par des procédés chimiques.

Les paillettes de mica mises en œuvre sont les produits habituellement disponibles dans le commerce. Ces paillettes peuvent être utilisées à l'état brut, mais dans certains cas, dans le but d'améliorer l'accrochage entre le mica et la résine, il peut être avantageux de leur faire subir un traitement de surface connu en soi.

Selon une variante très intéressante de l'invention, les substrats métallisés tels que décrits ci-avant comportent en outre une seconde feuille métallique (c') située contre la face libre non encore métallisée de la seconde peau (b') ou (b).

Les diverses couches (a) (b) (b') (c) ou (a) (b) (b') (c) (c') sont liées les unes aux autres de manière permanente par des liaisons chimiques ou de collage.

L'âme centrale (a) a un poids qui représente en général 50 à 95% du poids du substrat métallisé. Sa fonction essentielle est celle d'assurer le remplissage du substrat métallisé de manière à lui permettre de présenter l'épaisseur requise qui est généralement comprise entre 1 et 3 mm. Les substrats les plus fréquemment employés ont une épaisseur de 1,5 à 1,6 mm.

Les deux peaux (b) et (b') ont pour fonctions essentielles, d'une part celle d'assurer la rigidité du substrat métallisé et d'autre part celle de constituer une couche adhésive pour les feuilles métalliques (c) et (c'). L'épaisseur totale des deux peaux (b) et (b') dans le substrat métallisé est évaluée entre environ 0,01 et 0,3 mm.

Dans l'âme centrale (a), la proportion pondérale de matière cellulosique ou de paillettes de mica, par rapport à l'ensemble charge de remplissage + résire, est généralement comprise entre 60% et 95% de préférence entre 65 et 90%.

La résine, constituant de l'âme centrale (a) et aussi des peaux (b) et (b'), est faite en matière polymérique thermodurcissable. Comme types de résines qui conviennent, on citera notamment: les résines du type phénolique telles que par exemple les condensats de phénol, résorcinol, crésol ou xylénol avec du formaldéhyde ou du furfural; les résines du type polyester insaturé préparées par exemple par réaction d'un anhydride d'acide dicarboxylique non saturé avec un polyalkylèneglycol; les résines du type époxy telles que par exemple les produits de réaction de l'épichlorhydrine sur le bisphénol A; les résines du type polyimide telles que par exemple celles obtenues par réaction entre un N,N'-bis-imide d'acide dicarboxylique non saturé, une polyamine primaire et éventuellement un adjuvant approprié.

Comme indiqué ci-avant la résine faisant partie de l'âme centrale (a) peut être identique ou différente de celle faisant partie des peaux (b) et (b').

La résine peut être à l'état de prépolymère thermodurcissable (présentant un point de ramollissement et encore soluble dans certains solvants) pour un stade intermédiaire de réalisation du substrat métallisé ou à l'état complètement réticulé (infusible et totalement insoluble) dans la pièce finie telle qu'elle est utilisée normalement.

De manière préférentielle, la résine faisant partie de l'âme centrale (a) est du même type que celle faisant partie des peaux (b) et (b') et elle consiste en une résine du type polyimide obtenue par réaction entre un N,N'-bis-imide d'acide dicarboxylique insaturé et une polyamine primaire selon les indications données dans le brevet français No. 1 555 564, dans les brevets américains No. 3 562 223 et 3 658 764 et dans la réissue américaine No. 29 316. La résine polyimide peut encore être obtenue par réaction entre le bis-imide, la polyamine et divers adjuvants tels que par exemple des mono-imides (selon la brevet français No. 2 046 498), des monomères, autres que des imides, comportant un ou plusieurs groupements polymérisables du type $CH_2 = C<$ (selon le brevet français No. 2 094 607), des polyesters insaturés (selon le brevet français No. 2 102 878) ou des composés organosiliciques hydroxylés (selon le brevet français No. 2 422 696). Dans le cas où l'on utilise de pareils adjuvants, il faut rappeler que la résine polyimide peut être obtenue soit en chauffant directement les trois réactifs (bis-imide, polyamine et adjuvant) ensemble, soit en chauffant le produit de réaction ou le mélange de l'adjuvant avec un prépolymère de bis-imide et de polyamine préalablement préparé.

Dans ce qui suit, l'expression «prépolymère thermodurcissable» doit être entendue, quand elle s'adresse aux polyimides préférés, comme couvrant un matériau polymérique, présentant un point de ramollissement et encore soluble dans certains solvants, qui peut être: soit le produit de réaction d'un bis-imide avec une polyamine; soit le produit de réaction d'un bis-imide, d'une polyamine avec un adjuvant; soit le produit de réaction d'un prépolymère de bis-imide et de polyamine avec un adjuvant; soit encore le mélange d'un prépolymère de bis-imide et de polyamine avec un adjuvant.

Plus préférentiellement encore, on utilise dans la présente invention une résine polyimide issue de la réaction entre un bis-maléimide comme le N,N'-4,4'-diphénylméthane bis-maléimide et une diamine primaire comme le diamino-4,4' diphénylméthane et éventuellement l'un des divers adjuvants précités.

Il doit être entendu que la résine polyimide faisant partie de l'âme centrale (a) peut présenter le cas échéant une composition chimique identique ou différente de celle de la résine polyimide faisant partie des peaux (b) et (b'). C'est ainsi que, lorsque l'âme centrale (a) comporte une charge en matière cellulosique, il est tout spécialement favorable que la résine polyimide faisant partie de ladite âme centrale soit de préférence une résine polyimide issue de la réaction entre le bis-imide, la polyamine et l'un des adjuvants précités, notamment un composé organosilicique hydroxylé. La résine polyimide faisant partie des peaux (b) et (b') peut, quant à elle, avoir alors la même composition chimique ou résulter simplement de la réaction entre le bis-imide et la polyamine.

Les composés organosiliciques hydroxylés qui conviennent bien sont, par exemple, des huiles méthylphénylpolysiloxaniques α, ω dihydroxylées ayant de 4 à 9% en poids de groupements hydroxyles.

S'agissant des peaux (b) et (b'), la proportion pondérale de charge de renforcement, par rapport à l'ensemble charge de renforcement + résine, est généralement comprise entre 20% et 90%, et de préférence entre 40 et 70%.

La ou les feuilles métalliques utilisées présentent les caractéristiques connues de l'homme de métier et rappelées ci-avant. On fait appel de préférence à des feuilles de cuivre ayant une épaisseur comprise entre 15 et 70 μm. L'épaisseur le plus courante est de 35 μm.

Comme indiqué ci-avant, les peaux (b) et (b') sont constituées par l'association d'une charge de renforcement avec une résine. Plus précisément cette association est une imprégnation. L'imprégnation de la charge peut être faite, de manière classique, par voie collodion c'est-à-dire au moyen d'une solution d'un prépolymère thermodurcissable dans un solvant adéquat, par exemple un solvant polaire tel que diméthylformamide, N-méthylpyrrolidone, diméthylacétamide, diéthylformamide, N-acétylpyrrolidone. Mais pour s'affranchir de l'emploi de solvant de résoudre complètement le problème de pollution dont on a parlé ci-avant, on peut imgréger la charge à sec par poudrage avec le prépolymère thermodurcissable ou au moyen d'une dispersion aqueuse de prépolymère, lorsqu'il s'agit d'un prépolymère polyimide, on peut suivre les diverses techniques décrites dans les brevets français No. 2 110 619 et 2 156 452. Ces procédés conduisent à l'obtention des préimprégnés (ii) et (IVi) constitués par une charge de renforcement et un prépolymère. Lors des traitements ultérieurs (pressage et chauffage de l'empilement dont on a parlé ci-avant, ces préimprégnés se transforment par réticulation du prépolymère en peaux (b) et (b').

Le matériau qui se transforme pendant lesdits traitements ultérieurs en âme centrale (a) (ou matériau précurseur de l'âme centrale) est un feutre ou un compound constitué par une matière cellulosique ou du mica et un prépolymère thermodurcissable. Le feutre est réalisé par voie papetière tandis que le compound est réalisé par voie à sec.

Selon la voie papetière, on incorpore directement l'ensemble des ingrédients dans un mélangeur appelé «pile» par les papetiers, c'est-à-dire à la fois l'eau, la charge de remplissage (matière cellulosique ou mica) et le liant (prépolymère thermodurcissable) sous forme de poudre. A partir de la pâte obtenue on forme ensuite, sur une machine à papier, le feutre dont on extrait l'eau, d'une part par essorage et application du vide, d'autre part par séchage à une température de l'ordre de 70° à 110 °C, en général par passage du feutre dans une étuve ventilée. Dans ce feutre, le liant se trouve toujours au stade de prépolymère. Le feutre ainsi préparé présente une densité comprise entre 0,3 et 2, alors que, au stade final, c'est-à-dire après pressage du feutre et durcissement du prépolymère, la densité de l'âme centrale est de 1,5 à 2,7 environ.

Selon la voie à sec, la charge et le prépolymère thermodurcissable sont simplement mélangés à sec pour conduire à un compound pulvérulent. Le compound ainsi obtenu est soit moulé directement avec les préimprégnés (ii) et (IVi) et une ou deux feuilles métalliques (i) et (Vi), soit de préférence soumis au préalable à une opération de frittage pour le rendre plus facilement manipulable en vue de la préparation du substrat métallisé.

Selon la voie à sec, lorsque la charge est du mica, il est tout spécialement favorable de faire appel à des paillettes de mica ayant subi un traitement préalable de surface. Ce traitement consiste notamment à enrober les paillettes de mica à l'aide d'un alcoxysilane comportant un ou plusieurs groupements insaturés éthyléniquement, la quantité d'agent de traitement représentant généralement 0,1 à 3% du poids de la charge micacée. Comme alcoxysilanes qui conviennent on citera par exemple le vinyltriéthoxysilane, le méthylvinyldiéthoxysilane, le vinyltris(méthoxyéthoxy)silane.

Il doit être entendu que les proportions pondérales de charge de remplissage (pour le feutre ou le compound), de charge de renforcement (pour les préimprégnés) et de prépolymère thermodurcissable qui sont utilisées pour la fabrication des constituants (ii), (iii) et (IVi) correspondent pratiquement à celles indiquées ci-avant à propos de la définition de l'âme centrale (a) et des peaux (b) et (b'). Il doit être entendu aussi que le constituant (iii), qui est le précurseur de l'âme centrale (a), doit posséder un poids représentant pratiquement, en général, 50% à 95% du poids du substrat métallisé à obtenir.

Pour la réalisation des substrats métallisés conformes à l'invention, on place sur un plateau d'une presse les constituants (i), (ii), (iii), (IVi) et éventuellement (Vi) définis ci-avant. On presse alors fortement l'ensemble. Plus précisément l'ensemble est pressé, généralement entre 10 et 300 bars, à une température permettant un ramollissement du prépolymère présent dans les différents constituants.

Dans le cas des prépolymères polyimides préférés obtenus à partir d'un bis-imide, d'une polyamine et éventuellement d'un des adjuvants précités (ayant en général un point de ramollissement compris entre 50° et 200 °C), la température de pressage se situe généralement entre 70° et 280 °C. De préférence, dans le but de permettre un accrochage (ou assemblage) efficace des différents constituants, la température est supérieure à 150 °C.

Ces conditions de température de pressage s'appliquent également aux autres types de prépolymères thermodurcissables entrant dans le cadre de la présente invention. En général, le chauffage des prépolymères permet d'obtenir successivement leur ramollissement et leur durcissement. On peut naturellement procéder à un recuit de l'ensemble par exemple pendant quelques heures à 200 °C ou plus.

La technique de fabrication des substrats métallisés conformes à l'invention qui vient d'être décrite présente de nombreux avantages.

Comme on l'a déjà mentionné, cette fabrication est simplifiée du fait de l'emploi d'un nombre restreint de constituants et elle permet de s'affranchir, en tout ou partie, de processus d'imprégnation de structure de renforcement par voie collodion qui sont polluants.

Mais il y a d'autres avantages. La préparation du précurseur de l'âme centrale (a) par voie papetière (feutre) est un procédé à grand rendement. De plus, la voie papetière autorise le recyclage des déchets: il y a aucun inconvénient à réintroduire dans la pile les déchets de feutres formés avant séchage. De même la voie à sec (compound) passant par une préforme frittée supprime aussi l'existence des déchets. Par ailleurs, on note qu'il n'y a pratiquement pas de fluage de polyimide lors du pressage final à chaud. En définitive, cette possibilité de recyclage, liée au fluage pratiquement nul lors du pressage, assure une perte très faible de résine en cours de fabrication.

Le niveau des caractéristiques des substrats métallisés conformes à la présente invention (notamment caractéristiques mécaniques; résistance à l'arrachement des feuilles métalliques; tenue thermique; tenue à l'eau; caractéristiques électriques) est totalement satisfaisant et compatible avec un usage dans l'industrie électronique.

Les exemples suivants donnés à titre non limitatif illustrent l'invention et montrent comment elle peut être mise en oeuvre.

Exemple 1

Dans cet exemple, on détaille la technique de fabrication d'un substrat bi-cuivré (appelé encore copper-clad) comprenant une âme centrale faite à partir d'un feutre de papier, en sandwich entre deux peaux faites à partir d'un tissu de verre imprégné.

1) Réalisation du feutre de papier:

Dans le mélangeur (appelé pile) d'une machine papetière, on charge:

une pâte à papier de type kraft, non blanchie, constituée par 276 g de matière cellulosique dispersée dans 8 litres d'eau;

83 g d'une poudre d'un prépolymère préparé à partir de N,N'-4,4'-diphénylméthane-bis-maléimide et de diamino-4,4' diphénylméthane (rapport molaire bis-imide/diamine = 2,5) présentant un point de ramollissement de 70 °C;

35,5 g d'huile méthylphénylpolysiloxane-α, ω dihydroxylée comportant 7% en poids de groupements hydroxyles;

15,1 g d'une solution aqueuse contenant:
- 1,5 g d'alcool polyvinylique (Rhodoviol 20/140 de la Société RHONE-POULENC)
- 1,8 g de propylèneglycol
- 0,09 g d'acide sorbique

L'alcool polyvinylique, le propylène glycol et l'acide sorbique sont des ingrédients bien connus dans les procédés de préparation de papiers.

L'ensemble est homogénéisé par agitation pendant 1 heure environ. Afin de faciliter le malaxage, la pâte est diluée par ajout d'un peu d'eau (environ 3 litres).

Après malaxage, la pâte est introduite, par portion de 2800 g environ, dans une machine à papier du type: appareil «formette Franck» équipé d'une grille de forme carrée de 300 mm de côté, à maille carrée de 120 μm de côté. On élimine chaque fois l'eau par égouttage naturel et application du vide (pression réduite à 50 mm de mercure). Les divers feutres obtenus sont séchés à 90°–100 °C, pendant 2 heures, en étuve ventilée. Ces feutres ont des dimensions d'environ 300 × 300 × 10 mm et présentent chacun un poids compris entre 110 g et 140 g. Ils comprennent environ 70% en poids de fibres cellulosiques et 30% en poids de prépolymère polyimide (prépolymère bis-imide/diamine + composé organosilicique). Les autres composants: alcool polyvinylique, propylèneglycol, acide sorbique, sont solubles dans l'eau et sont totalement éliminés dans la phase aqueuse qui estrecyclée.

2) Réalisation du tissu de verre imprégné:

On prépare un collodion comprenant 50% en poids de N-méthylpyrrolidone et 50% en poids d'un prépolymère polyimide préparé à partir de N,N'-4,4'-diphénylméthane-bis-maléimide et de diamino-4,4' diphénylméthane (rapport molaire bis-imide/diamine = 2,5) présentant un point de ramollissement de 100 °C.

Ce collodion est déposé au pinceau sur les deux faces d'un tissu de verre, du type 278 de Tissaverre (toile de 200 g/m²), de manière à avoir un rapport pondéral tissu de verre/prépolymère polyimide de 65/35. Le collodion est déposé en deux passes séparées par un séchage de 1 mm à 140 °C. Après la deuxième passe le séchage est de 10 mn à 140 °C en étuve ventilée. On découpe dans la nappe de préimprégné deux pièces ayant les dimensions suivantes: 300 × 300 × 0,25 mm et pesant chacune 27,5 à 28 g, destinées à constituer les deux supports entourant le feutre de papier.

3) Réalisation du copper-clad:

On empile sur le plateau d'une presse successivement:

une première feuille de cuivre de 33 μm d'épaisseur, du type TC Foil, ayant une forme carrée de 300 mm de côté,
un des préimprégnés,
un feutre de 124 g,
le second préimprégné,
une seconde feuille de cuivre de 35 μm,
puis on presse l'ensemble:

pendant 15 mn à 160 °C sous 25 bars (avec dégazage à la 3e et 5e minute),

puis pendant 2 heures à 180 °C sous 25 bars (en affichant la température de 180 °C au bout des 15 mn sans interruption de cycle).

Il n'y a pas de fluage de résine pure.

On obtient finalement un copper-clad de 300 × 300 × 1,6 mm et pesant 237 g. Dans cet article le poids de l'âme centrale correspond à environ 52% du poids total du copper-clad.

Les résistances mécaniques en flexion du copper-clad sont les suivantes (mesures selon la norme ASTM D 790).

– résistance en flexion à 20 °C environ: 34,5 kg/mm²,

– module en flexion à 20 °C environ: 1900 kg/mm².

Les valeurs de peeling (arrachement) du cuivre sont les suivantes: l'arrachement est réalisé, perpendiculairement au plan de collage, sur une bande de copper-clad de 1 cm de largeur,

| | Temps 0 | Après 250 heures à 150°C | après 500 heures à 150°C | Après 1000 heures à 150°C |
|---|---|---|---|---|
| Moyennes en kg/cm | 1,77 | 1,85 | 1,87 | 1,92 |

Les valeurs de peeling sont très homogènes et le vieillissement thermique est plutôt favorable.

Exemple 2

Dans cet exemple, on détaille la technique de fabrication d'un copper-clad comprenant une âme centrale faite à partir d'un feutre de mica en sandwich entre deux peaux faites à partir d'un tissu de verre imprégné.

1) Réalisation du feutre d'amiante:

Dans le mélangeur (appelé «pile») d'une machine papetière, on charge:

63,8 g de paillettes de mica du type Suzorite 60 S;

11,2 g de prépolymère polyimide préparé à partir de N,N'-4,4'-diphénylméthane-bis-maléimide et de diamino-4,4' diphénylméthane (rapport molaire bis-imide/diamine = 2,5) présentant un point de ramollissement de 70°;

0,5 l d'eau.

L'ensemble est homogénéisé par agitation pendant 10 mn, puis introduit dans la machine à papier Franck équipée cette fois d'une grille en forme de disque de 200 mm de diamètre à maille carrée de 120 µm de côté. Le feutre circulaire obtenu est séché à 100 °C, pendant 2 heures, en étuve ventilée. Il présente une épaisseur d'environ 2,5 mm et un poids de 71 g. Il comprend environ 85% en poids de mica et 15% en poids de prépolymère polyimide. Dans ce feutre circulaire de 200 mm de diamètre, on découpe, pour la suite des opérations, un carré (inscrit) de feutre de 140 mm de côté et pesant 45 g.

2) Réalisation du tissu de verre imprégné:

Il convient de se référer à l'exemple 1, partie 2). A noter que l'on découpe dans la nappe obtenue deux préimprégnés carrés de 140 mm de côté.

3) Réalisation du copper-clad:

On opère comme indiqué ci-avant à l'exemple 1, mais avec deux feuilles de cuivre carrées de 35 µm d'épaisseur et de 140 mm de côté.

Les conditions de pressage sont les suivantes:

15 mn à 160 °C sous 40 bars (avec dégazage à la 3e et 5e minute),

puis 1 heure à 180 °C sous 40 bars (en affichant la température de 180 °C au bout des 15 mn sans interruption de cycle).

Il n'y a pas de fluage de résine pure.

L'article obtenu est ensuite recuit pendant 24 heures à 200 °C.

Les caractéristiques du copper-clad sont les suivantes:

– dimensions: 140 × 140 × 1,6 mm; poids: 69,8 g; le poids de l'âme centrale correspond à environ 64% du poids total du copper-clad.

– résistance en flexion:
à 20 °C environ:     20,7 kg/mm²
à 180 °C:     18,4 kg/mm²
– module en flexion:
à 20 °C environ:     3250 kg/mm²
à 180 °C:     2755 kg/mm²
– peeling (temps 0): 1,6 kg/cm (valeur moyenne)
– coefficient de dilatation: $10 \times 10^{-6}$ cm/cm/ °C

Exemple 3

Dans cet exemple, on détaille la technique de fabrication d'un copper-clad comprenant une âme centrale faite à partir d'un compound de mica fritté en sandwich entre deux peaux faites à partir d'un tissu de verre imprégné.

1) Réalisation du compound fritté:

Dans un mélangeur industriel de type CNTA, on mélange à sec:

85 parties en poids de paillettes de mica du type Muscovite Adriss 16 mesh traitées avec 1% de vinyltriéthoxysilane (le traitement consiste habituellement à mélanger la charge avec le silane, puis à laisser reposer le mélange obtenu au contact de l'air pendant environ 3 jours),

et 15 parties en poids de prépolymère polyimide préparé à partir de N,N'-4,4'-diphénylméthane-bis-maléimide et de diamino-4,4' diphénylméthane (rapport molaire bis-imide/diamine = 2,5) présentant un point de ramollissement de 70 °C.

La durée de cette opération de mélange est d'environ 5 mn.

80 g du compound pulvérulent ainsi obtenu sont ensuite introduits dans un moule de 220 × 120 × 20 mm (entre deux feuilles d'aluminium pour faciliter le démoulage ultérieur), puis on porte le moule et son contenu à une température de 120°C et on applique une pression de 200 bars pendant 5 mn. On démoule ensuite à chaud. La forme frittée obtenue pèse 80 g. Elle comprend environ 85% en poids de mica et 15% en poids de prépolymère polyimide.

2) Réalisation du tissu de verre imprégné:

On opère comme indiqué à l'exemple 1, partie 2). A noter que l'on découpe dans la nappe obtenue deux préimprégnés rectangulaires de 220 × 120 mm.

3) Réalisation du copper-clad:

On utilise des feuilles de cuivre de 220 × 120 mm et de 35 µm d'épaisseur.

On empile sur le plateau d'une presse successivement: la première feuille de cuivre, un des préimprégnés, la forme frittée, le second préimprégné et la seconde feuille de cuivre, puis on presse l'ensemble pendant 45 mn à 250°C sous 200 bars. Il n'y a pas de fluage de résine pure. L'article obtenu est ensuite recuit pendant 24 heures à 200°C.

Les caractéristiques du copper-clad sont les suivantes:

– dimensions: 220 × 120 × 1,6 mm; poids: 107 g; le poids de l'âme centrale correspond à environ 75% du poids total du copper-clad.

– résistance en flexion:

| | |
|---|---|
| à 20°C environ: | 22,5 kg/mm² |
| à 200°C: | 17,8 kg/mm² |
| à 250°C: | 14,5 kg/mm² |

– module en flexion:

| | |
|---|---|
| à 20°C environ: | 2285 kg/mm² |
| à 200°C: | 1905 kg/mm² |
| à 250°C: | 1660 kg/mm² |

– peeling:

| | Temps 0 | Après 141 heures à 200°C | Après 500 heures à 200°C | Après 1000 heures à 200°C |
|---|---|---|---|---|
| Moyennes en kg/cm | 1,82 | 1,93 | 1,67 | 1,93 |

– variation du poids (en % par rapport au poids initial) pendant le vieillissement à 200°C:

après 141 heures:    $\Delta P = -0,1\%$
après 1000 heures:    $\Delta P = -1,5\%$

– test de reprise en eau au bout de 24 heures (variation du poids en % par rapport au poids initial):

dans la vapeur d'eau:    $\Delta P = +0,38\%$
immersion dans l'eau bouillante:$\Delta P = +0,74\%$

– caractéristiques électriques:

| Propriétés mesurées | Valeurs initiales | Après 24 heures dans l'eau |
|---|---|---|
| Rigidité diélectrique en KV/mm | 23 | 13 |
| Permittivité ε à 1 mHz | 3,6 | 3,9 |
| Tangente de l'angle de perte à 1 MHz | $8,4 \times 10^{-3}$ | $50 \times 10^{-3}$ |
| Résistance en Ω × cm | $12 \times 10^{14}$ | $2,5 \times 10^{14}$ |

– coefficient de dilatation: $10 \times 10^{-6}$ cm/cm/°C

## Revendications

1. Procédé de fabrication d'un substrat métallisé destiné à la réalisation de circuits imprimés, caractérisé en ce qu'il consiste à empiler successivement:

(i) – une feuille métallique conductrice électriquement,

(ii) – un premier préimprégné constitué par un tissu ou un non-tissé de fibres de verre, d'amiante ou de fibres synthétiques thermostables imprégné au moyen d'un prépolymère thermodurcissable sous forme non réticulée,

(iii) – un feutre ou un compound constitué par une matière cellulosique ou des paillettes de mica et un prépolymère thermodurcissable sous forme non réticulée,

(IVi) – un second préimprégné tel que défini sous (ii),

(Vi) – éventuellement une seconde feuille métallique identique à (i),

puis à presser l'empilement à une température permettant l'assemblage et la réticulation des différents éléments.

2. Procédé selon la revendication 1, caractérisé en ce que le constituant (iii) représente 50 à 95% du poids du substrat métallisé.

3. Procédé selon les revendications 1 et 2, caractérisé en ce que, dans le constituant (iii), la proportion pondérale de matière cellulosique ou de paillettes de mica, par rapport à l'ensemble charge de remplissage + prépolymère thermodurcissable, est comprise entre 60% et 95%.

4. Procédé selon les revendications 1 à 3, caractérisé en ce que, dans les constituants (ii) et (IVi), la proportion pondérale de charge de renforcement, par rapport à l'ensemble charge de renforcement + prépolymère thermodurcissable, est comprise entre 20% et 90%.

5. Procédé selon les revendications 1 à 4, caractérisé en ce que le prépolymère thermodurcissable faisant partie des constituants (ii), (iii) et (IVi) est choisi dans le groupe formé par: les prépolymères du type phénolique; les prépolymères du type polyester insaturé; les prépolymères du type époxy; les prépolymères du type polyimide.

6. Procédé selon les revendications 1 à 5, caractérisé en ce que le prépolymère utilisé dans le constituant (iii) est du même type que celui utilisé dans les constituants (ii) et (IVi) et consiste en un prépolymère de type polyimide obtenu par réaction entre un N,N'-bis-imide d'acide dicarboxylique non saturé, une polyamine primaire et éventuellement un adjuvant tel que, notamment, un mono-imide, un monomère polymérisable comportant un ou plusieurs groupements du type $CH_2 = C<$, un polyester insaturé, un composé organosilicique hydroxylé.

7. Procédé selon la revendication 6, caractérisé en ce que, lorsque le constituant (iii) comporte une charge faite en matière cellulosique, le prépolymère polyimide faisant partie dudit constituant (iii) est obtenu par réaction entre un N,N'-bis-imide d'acide dicarboxylique non saturé, une polyamine primaire et un composé organosilicique hydroxylé.

8. Procédé selon les revendications 1 à 7, caractérisés en ce que la ou les feuilles métalliques utilisées sont des feuilles de cuivre.

9. Procédé selon les revendications 1 à 8, caractérisé en ce que l'on presse entre 10 et 300 bars et entre 70° et 280 °C l'empilement des différents constituants.

10. Procédé selon les revendications 1 à 9, caractérisé en ce que le constituant (iii) est un feutre réalisé par voie papetière.

11. Procédé selon les revendications 1 à 9 caractérisé en ce que le constituant (iii) est un compound préparé par simple mélange à sec de la charge et du prépolymère thermodurcissable.

12. Procédé selon la revendication 11, caractérisé en ce que le compound est soumis à une opération de frittage.

13. Procédé selon les revendications 11 et 12, caractérisé en ce que, lorsque la charge de remplissage consiste en des paillettes de mica, ladite charge subit au préalable un traitement de surface à l'aide d'un alcoxysilane comportant un ou plusieurs groupements insaturés éthyléniquement.

**Claims**

1. Process for the manufacture of a metallized substrate intended for the production of printed circuits, characterized in that it consists in stacking in succession:

(i) – an electrically conducting metal sheet,

(ii) – a first prepreg consisting of a cloth or nonwoven made of glass or asbestos fibres or of heat-stable synthetic fibres, which is impregnated with a thermosettable prepolymer in an uncrosslinked form,

(iii) – a felt or a composition consisting of a cellulose substance or mica flakes and a thermosettable prepolymer in an uncrosslinked form,

(IVi) – a second prepreg as defined under (ii),

(Vi) – optionally a second metal sheet identical to (i), and then pressing the stack at a temperature permitting the assembly and the crosslinking of the various components.

2. Process according to Claim 1, characterized in that component (iii) represents 50 to 95% by weight of the metallized substrate.

3. Process according to Claims 1 and 2, characterized in that, in component (iii), the weight proportion of cellulose substance or of mica flakes, relative to the combined total of filling charge + thermosettable prepolymer is between 60% and 95%.

4. Process according to Claims 1 to 3, characterized in that, in components (ii) and (IVi), the weight proportion of reinforcement charge, relative to the combined total of reinforcement charge + thermosettable prepolymer, is between 20% and 90%.

5. Process according to Claims 1 to 4, characterized in that the thermosettable prepolymer forming part of components (ii), (iii) and (IVi) is chosen from the group formed by: phenolic type prepolymers, unsaturated polyester type prepolymers, epoxy type prepolymers, and polyimide type prepolymers.

6. Process according to Claims 1 to 5, characterized in that the prepolymer employed in component (iii) is of the same type as that employed in components (ii) and (IVi) and consists of a polyimide type prepolymer obtained by a reaction between an N,N'-bis-imide of an unsaturated dicarboxylic acid, a primary polyamine and optionally an adjuvant such as, in particular, a mono-imide, a polymerizable monomer containing one or more groups of the type $CH_2 = C<$, an unsaturated polyester, and a hydroxylated organosilicic compound.

7. Process according to Claim 6, characterized in that, when component (iii) incorporates a charge made of a cellulose substance, the polyimide prepolymer forming part of the said component (iii) is obtained by a reaction between an N,N'-bis-imide of an unsaturated dicarboxylic acid, a primary polyamine and a hydroxylated organosilicic compound.

8. Process according to Claims 1 to 7, characterized in that the metal sheet or sheets employed are copper sheets.

9. Process according to Claims 1 to 8, characterized in that the stack of the various components is pressed at between 10 and 300 bars and between 70° and 280 °C.

10. Process according to Claims 1 to 9, characterised in that component (iii) is a felt obtained by a papermaking process.

11. Process according to Claims 1 to 9, characterized in that component (iii) is a compound prepared by simple dry mixing of the charge and the thermosettable prepolymer.

12. Process according to Claim 11, characterized in that the compound is subjected to a sintering operation.

13. Process according to Claims 11 and 12, characterized in that, when the filling charge consists of mica flakes, the said charge is first subjected to a surface treatment with an alkoxysilane containing one or more ethylenically unsaturated groups.

**Patentansprüche**

1. Verfahren zur Herstellung eines metallisierten Substrats für gedruckte Schaltungen, dadurch gekennzeichnet, dass man nacheinander aufeinander schichtet:

(i) eine elektrisch leitende Metallfolie,

(ii) ein erstes Prepreg, bestehend aus einem Gewebe oder Vlies aus Glas- oder Asbestfasern oder aus thermostabilen synthetischen Fasern, imprägniert mit mindestens einem unvernetzten wärmehärtbaren Prepolymeren,

(iii) einen Filz oder ein Compound, bestehend aus einem cellulosischem Material oder aus Glimmerflitter bzw. -schuppen und einem nicht vernetzten wärmehärtbaren Prepolymeren,

(IVi) ein zweites Prepreg wie unter (ii) definiert,

(Vi) gegebenenfalls eine zweite Metallfolie, identisch mit (i),

und dann das Schichtmaterial bei einer Temperatur zusammenpresst, bei der sich die verschiedenen Schichtelemente bzw. -teile miteinander verbinden und vernetzen.

2. Verfahren nach Anspruch 1, dadurch gekennzeichnet, dass die Komponente (iii) 50 bis 95 Gew.-% des metallisierten Substrats ausmacht.

3. Verfahren nach den Ansprüchen 1 und 2, dadurch gekennzeichnet, dass in der Komponente (iii) der Gewichtsanteil des cellulosischen Materials oder des Glimmerflitters, bezogen auf die Gesamtmenge aus Füllstoff und wärmehärtbarem Prepolymeren, 60 bis 95% ausmacht.

4. Verfahren nach den Ansprüchen 1 bis 3, dadurch gekennzeichnet, dass in den Komponenten (ii) und (IVi) der Gewichtsanteil des verstärkenden Füllstoffes, bezogen auf die Gesamtmenge aus verstärkendem Füllstoff und wärmehärtbarem Prepolymeren, 20 bis 90% ausmacht.

5. Verfahren nach den Ansprüchen 1 bis 4, dadurch gekennzeichnet, dass das wärmehärtbare Prepolymer, das Bestandteil der Komponenten (ii), (iii) und (IVi) ist, ausgewählt wird aus der Gruppe bestehend aus: den Phenolharz-Prepolymeren, ungesättigten Polyester-Prepolymeren, Epoxyharz-Prepolymeren und Polyimidharz-Prepolymeren.

6. Verfahren nach den Ansprüchen 1 bis 5, dadurch gekennzeichnet, dass in der Komponente (iii) ein gleichartiges Prepolymer verwendet wird, wie in den Komponenten (ii) und (IVi) und aus einem Polyimid-Prepolymeren besteht, das durch Umsetzung eines N,N'-Bis-imids einer ungesättigten Dicarbonsäure, eines primären Polyamins und gegebenenfalls eines Zusatzes wie vor allem eines Mono-imids, eines polymerisierbaren Monomeren, enthaltend eine oder mehrere Gruppen $CH_2 = C<$, eines ungesättigten Polyesters oder einer hydroxylierten Organosiliciumverbindung erhalten worden ist.

7. Verfahren nach Anspruch 6, dadurch gekennzeichnet, dass – wenn die Komponente (iii) einen Füllstoff aus cellulosischem Material enthält – das Polyimid-Prepolymer, das Teil dieser Komponente (iii) ist, durch Umsetzung eines N,N'-Bis-imids einer ungesättigten Dicarbonsäure, eines primären Polyamins und einer hydroxylierten Organosiliciumverbindung erhalten worden ist.

8. Verfahren nach den Ansprüchen 1 bis 7, dadurch gekennzeichnet, dass die verwendete(n) Metallfolie(n) (eine) Kupferfolie(n) ist bzw. sind.

9. Verfahren nach den Ansprüchen 1 bis 8, dadurch gekennzeichnet, dass man den Schichtaufbau aus den verschiedenen Komponenten bei 100 bis 330 bar und 70 bis 280 °C verpresst.

10. Verfahren nach den Ansprüchen 1 bis 9, dadurch gekennzeichnet, dass die Komponente (iii) ein nach der Art der Papierherstellung erhaltener Filz ist.

11. Verfahren nach den Ansprüchen 1 bis 9, dadurch gekennzeichnet, dass die Komponente (iii) ein durch einfaches Trocken-Vermischen von Füllstoff und wärmehärtbarem Prepolymeren hergestellter Compound ist.

12. Verfahren nach Anspruch 11, dadurch gekennzeichnet, dass der Compound einem Sintervorgang unterworfen wird.

13. Verfahren nach den Ansprüchen 11 und 12, dadurch gekennzeichnet, dass – wenn der Füllstoff aus Glimmerflitter besteht – dieser Füllstoff zunächst einer Oberflächenbehandlung mit Hilfe eines Alkoxysilans unterworfen wird, das eine oder mehrere ethylenisch ungesättigte Gruppen aufweist.